# EUROPÄISCHE PATENTSCHRIFT

(11) **EP 0 526 843 B1**
(45) Veröffentlichungstag und Bekanntmachung des Hinweises auf die Patenterteilung: **05.10.1994**
(21) Anmeldenummer: 92113050.6
(22) Anmeldetag: 31.07.1992
(51) Int. Cl.: H01L 21/00

(54) **Aufnahmevorrichtung für über einen Transfermechanismus in eine Apparatur einzubringende Proben**
Holder for a sample insertable in an apparatus using a transfer mechanism
Support pour un échantillon destiné à être inséré dans un appareil à l'aide d'un mécanisme de transfert

(30) Priorität: 05.08.1991 DE 4125877
(43) Veröffentlichungstag der Anmeldung: 10.02.1993
(73) Patentinhaber: FORSCHUNGSZENTRUM JÜLICH GMBH, 52425 Jülich (DE)
(72) Erfinder: Wördenweber, Roger, Dr., W-5162 Niederzier (DE)

(56) Entgegenhaltungen:
- GB-A- 2 137 414
- US-A- 4 958 061
- PATENT ABSTRACTS OF JAPAN, vol. 9, no. 285 (P-404), 12. November 1985 ; & JP-A-60 125 811

## Beschreibung

Die Erfindung bezieht sich auf eine Aufnahmevorrichtung für eine über einen Transfermechanismus in eine Apparatur einzubringende und in dieser aufzuheizende Probe.

Bei einer Probe der bezeichneten Art kann es sich beispielsweise um Substrate handeln, auf denen in eine hierfür geeigneten Apparatur ein Hochtemperatursupraleiter bei Temperaturen im Bereich von ca. 500 - 800°C durch Deposition hergestellt wird. Die Substrate sind an einem Probenhalter befestigt und werden mit diesem - beide zusammen werden als "Probe" bezeichnet - in die Apparatur eingebracht.

Bei der Durchführung der Deposition bereitet die genaue Kontrolle der Substrattemperatur Schwierigkeiten. Eine meist höhere Hintergrundtemperatur, die bei einem schlechten Wärmekontakt zwischen Heizung und Substrat nötig wäre, ist z.B. wegen der damit verbundenen Kontaminationsgefahr unerwünscht. Die gewünschte, optimale Wärmeankopplung läßt sich zwar durch Aufkleben oder Anpressen (mit oder ohne Zwischenmaterial) der Probe an den Heizung oder durch eine die Probe möglichst optimal umhüllende Heizung realisieren. Diese Lösungsmöglichkeiten sind jedoch für einen mit einem Probentransfermechanismus ausgestatteten Prozeß nicht oder nur sehr schwierig realisierbar.

Es ist daher Aufgabe der Erfindung, eine Aufnahmevorrichtung der eingangs bezeichneten Art, d.h. für über eine Transfermechanismus einzubringende Proben zu schaffen, die eine genaue Kontrolle der Probentemperatur gewährleistet.

Diese Aufgabe wird erfindungsgemäß durch Halterungen gelöst, in denen die Probe nach dem Einbringen aufliegt und in der Nähe einer Heizung gehalten wird sowie durch Bimetallstreifen, von denen die Probe an der der Heizung abgewandten Seite erfaßt und beim Aufheizvorgang gegen die Heizung gedrückt wird.

Das erfindungsgemäße Prinzip beruht auf der Ausnützung der vorhandenen Temperatur und deren Einfluß auf die Bimetallstreifen, die entsprechend den gegebenen Geometrien dimensioniert sind. Bei niedriger Temperatur bzw. Raumtemperatur liegt die Probe in der Aufnahmevorrichtung, ohne daß auf sie Preßdruck ausgeübt wird. Wird nun die Temperatur der Heizung erhöht, so erhöht sich auch die Temperatur des oder der Bimetallstreifen(s). Dies führt zu einer Verbiegung der Metallstreifen hin zur Heizung. Die Probe wird nun von den Bimetallstreifen angehoben und bei ausreichender Temperatur schließlich gegen die Heizung gedrückt, wodurch die gewünschte Temperaturankopplung erzielt wird. Nach Abkühlen der Heizung und somit der Bimetallstreifen liegt die Probe wieder frei auf der Halterung und kann nun entladen bzw. weiter behandelt werden.

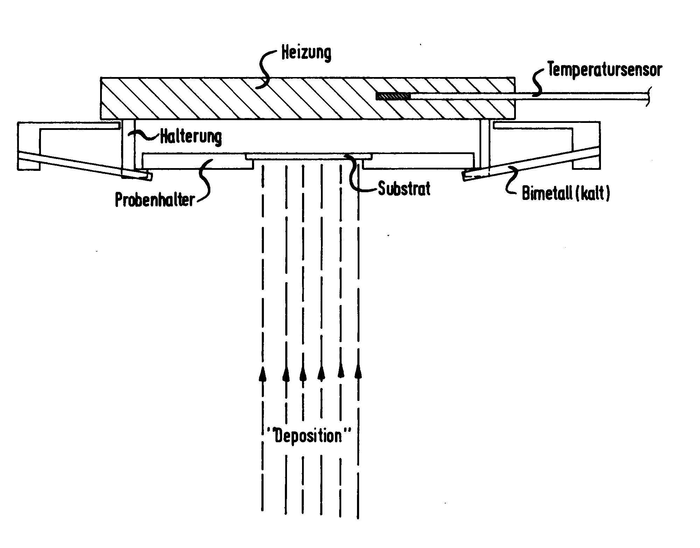

In der Zeichnung ist eine Ausführungsform der Aufnahmevorrichtung gemäß der Erfindung schematisch dargestellt und wird im folgenden näher erläutert: Unterhalb einer Heizung mit Temperatursensor liegt ein Probenhalter mit Substrat bei noch niedriger Temperatur auf Halterungen auf. Der Probenhalter wird dabei seitlich von Bimetallstreifen erfaßt.

Während des Heizvorganges biegen sich die Bimetallstreifen nach oben zur Heizung und heben den Probenhalter an. Bei hinreichender Temperatur wird dieser an die Heizung gedrückt. Im vorliegenden Falle ist die Deposition nach oben gerichtet.

## Patentansprüche

1. Aufnahmevorrichtung für eine über einen Transfermechanismus in eine Apparatur einzubringende und in dieser aufzuheizende Probe,
**gekennzeichnet durch**
Halterungen, in denen die Probe nach dem Einbringen aufliegt und in der Nähe einer Heizung gehalten wird und durch Bimetallstreifen, von denen die Probe an der der Heizung abgewandten Seite erfaßt und beim Aufheizvorgang gegen die Heizung gedrückt wird.

## Claims

1. A receiver device for a sample to be introduced via a transfer mechanism into an apparatus and to be heated in the latter, characterised by mountings, in which the sample is supported after its introduction, is held in the vicinity of the heater, and is pressed against the heater during the heating operation by bimetallic strips by which the sample is grasped on its side remote from the heater.

## Revendications

1. Dispositif de logement pour un échantillon devant être inséré dans un dispositif par l'intermédiaire d'un mécanisme de transfert et devant être chauffé dans ce dispositif, caractérisé par des dispositifs de retenue, dans lesquels l'échantillon est disposé après son insertion et est maintenu à proximité du dispositif de chauffage, et par des bilames, par lesquels l'échantillon est saisi sur le côté situé à l'opposé du dispositif de chauffage et est repoussé contre ce dernier lors de l'opération de chauffage.
